# EUROPEAN PATENT APPLICATION

(11) **EP 4 661 621 A1**
(43) Date of publication of application: **10.12.2025**
(21) Application number: 25162102.5
(22) Date of filing: 06.03.2025
(51) Int. Cl.: H10D 84/01, H10D 84/83, H10D 84/85

(54) **N/P MOS GATE STACK AND METHOD OF MANUFACTURING THE SAME**

(30) Priority: 05.06.2024 KR 20240073699
(71) Applicant: Samsung Electronics Co., Ltd., Suwon-si, Gyeonggi-do 16677 (KR)
(72) Inventor: CHOI, Yonghyuk, 16677 Suwon-si, Gyeonggi-do (KR); SONG, Heechan, 16677 Suwon-si, Gyeonggi-do (KR); KIM, Dohyung, 16677 Suwon-si, Gyeonggi-do (KR); SONG, Philjong, 16677 Suwon-si, Gyeonggi-do (KR); LEE, Dongsoo, 16677 Suwon-si, Gyeonggi-do (KR); LEE, Hyeji, 16677 Suwon-si, Gyeonggi-do (KR)
(74) Representative: Kuhnen & Wacker Patent- und Rechtsanwaltsbüro PartG mbB

(57) **Abstract**

The n/p MOS gate stack includes a semiconductor substrate (1010) having an nMOS region and a pMOS region, an nMOS stack (100) including a first interface layer (1110), a first high dielectric layer (1120) formed on the first interface layer (1110), a first n-metal layer (1140) formed on the first high dielectric layer (1120), and a first upper electrode (1150) formed on the first n-metal layer (1140), which are formed in the nMOS region, and a pMOS stack (200) including a second interface layer (1210), a second high dielectric layer (1220) formed on the second interface layer (1210), a second p-metal layer (1230) formed on the second high dielectric layer (1220), a second n-metal layer (1240) formed on the second p-metal layer (1230), and a second upper electrode (1250) formed on the second n-metal layer (1240), which are formed in the pMOS region. The first high dielectric layer (1120) includes a first dipole material (1124), and the second p-metal layer (1230) includes a second dipole material (1234).

## Description

### BACKGROUND

### 1. Field of the Invention

One or more embodiments relate to an n/p metal-oxide-semiconductor (MOS) gate stack and a method of manufacturing the n/p MOS gate stack.

### 2. Description of the Related Art

Metal-oxide-semiconductor (MOS) devices are basic constituent elements in some integrated circuits. A gate stack including dual dipoles may be utilized to effectively control an operating voltage in an nMOS and a pMOS. For this, individual dipole material layers may be formed. However, at this time, a metal gate and a dipole material may react. Atomic layer deposition (ALD) is mainly used, but gate leakage (Jg) deterioration may occur due to LaCl formation. In the structure, a structure in which an n-metal layer gate is deposited after depositing LaO in an nMOS region, and an n-metal layer is deposited together on a structure in which a p-metal layer and AlO are laminated in a pMOS region is used. LaO is used as a dipole material in the nMOS region, and AlO is dualized and used as a dipole material in the pMOS region, thereby improving n/p MOS controllability and reducing a threshold voltage.

### SUMMARY

According to an aspect, there is provided an n/p metal-oxide-semiconductor (MOS) gate stack including a semiconductor substrate having an nMOS region and a pMOS region, an nMOS stack on the nMOS region, the nMOS stack comprising a first interface layer, a first high dielectric layer, a first n-metal layer, and a first upper electrode sequentially stacked, and a pMOS stack on the pMOS region, the pMOS stack including a second interface layer, a second high dielectric layer formed on the second interface layer, a second p-metal layer formed on the second high dielectric layer, a second n-metal layer formed on the second p-metal layer, and a second upper electrode formed on the second n-metal layer, which are formed in the pMOS region, wherein the first high dielectric layer includes a first dipole material, and the second p-metal layer includes a second dipole material. Throughout this specification, the term 'metal' as used herein includes, but is not limited to, elemental metals (e.g., titanium, aluminum, tungsten), metal alloys (e.g., titanium-aluminum alloys), and metal compounds such as metal nitrides (e.g., titanium nitride, tantalum nitride), metal carbides, and metal oxides, provided they exhibit metallic or metallic-like properties, in particular with respect to its electrical conductivity. The terms 'p-metal' and 'n-metal' may refer to any metal. In particular, the term 'p-metal' may refer to a metal or metal alloy layer incorporated into the gate stack of a metal-oxide-semiconductor (MOS) device, for use with p-type regions or p-channel transistors (PMOS devices). Likewise, the term 'n-metal' may refer to a metal or metal alloy layer incorporated into the gate stack of a metal-oxide-semiconductor (MOS) device, for use with n-type regions or n-channel transistors (NMOS devices).

According to another aspect, there is provided a method of manufacturing an n/p MOS gate stack, the method including preparing a substrate, forming a first interface layer in an nMOS region of the substrate and a second interface layer in a pMOS region of the substrate, forming a first high dielectric layer and a second high dielectric layer on the first interface layer and the second interface layer, respectively, forming a first p-metal layer and a second p-metal layer on the first high dielectric layer and the second high dielectric layer, respectively, exposing the first high dielectric layer by removing the first p-metal layer formed on the first high dielectric layer, forming a first dipole thin film and a second dipole thin film on the exposed high dielectric layer and the second p-metal layer, respectively, performing a heat treatment on the first dipole thin film and the second dipole thin film such that the first dipole thin film and the second dipole thin film diffuse into the exposed high dielectric layer and the second p-metal layer, respectively, exposing the first high dielectric layer and the second p-metal layer by removing a residue of the first dipole thin film and a residue of the second dipole thin film, forming, after removing the residue of the first dipole thin film and the residue of the second dipole thin film, a first n-metal layer and a second n-metal layer on the exposed first high dielectric layer and the exposed second p-metal layer, respectively, and forming a first upper electrode and a second upper electrode on the first n-metal layer and the second n-metal layer, respectively.

Additional aspects of example embodiments will be set forth in part in the description which follows and, in part, will be apparent from the description, or may be learned by practice of the disclosure.

### BRIEF DESCRIPTION OF THE DRAWINGS

These and/or other aspects, features, and advantages of the invention will become apparent and more readily appreciated from the following description of example embodiments, taken in conjunction with the accompanying drawings of which:
FIG. 1 illustrates a conceptual diagram of an n/p metal-oxide-semiconductor (MOS) gate stack according to at least one embodiment;
FIGS. 2 to 11 illustrate conceptual diagrams of an operation of manufacturing an n/p MOS gate stack of the present disclosure according to at least one embodiment;
FIG. 12 illustrates a perspective view of an n/p MOS gate stack having a three-dimensional (3D) fin field effect transistor (FinFET) structure according to at least one embodiment;
FIGS. 13A and 13B illustrate cross-sectional views of an n/p MOS gate stack having a 3D FinFET structure taken along lines A-A' and B-B' of FIG. 12;
FIGS. 14 to 23 illustrate conceptual diagrams of an operation of manufacturing an n/p MOS gate stack having a 3D FinFET structure according to at least one embodiment;
FIG. 24 illustrates a plan view schematically showing a portion of a semiconductor device according to at least one embodiment;
FIG. 25 illustrates cross-sectional views taken along lines C-C', D-D', and E-E' of FIG. 24; and
FIG. 26 illustrates a conceptual cross-sectional view of a semiconductor device having a cell over peri (COP) structure according to at least one embodiment.

### DETAILED DESCRIPTION

Hereinafter, embodiments will be described in detail with reference to the accompanying drawings. However, various alterations and modifications may be made to the embodiments and thus, the scope of the disclosure is not limited or restricted to the embodiments. The equivalents should be understood to include all changes, equivalents, and replacements within the idea and the technical scope of the disclosure.

Like reference numerals in the drawings denote like components, and sizes of components in the drawings may be exaggerated for convenience of explanation. In addition, embodiments to be described below are only examples, and various modifications from such embodiments may be possible. Additionally, when the terms "about" or "substantially" are used in this specification in connection with a numerical value and/or geometric terms, it is intended that the associated numerical value includes a manufacturing tolerance (e.g., ±10%) around the stated numerical value. Further, regardless of whether numerical values and/or geometric terms are modified as "about" or "substantially," it will be understood that these values should be construed as including a manufacturing or operational tolerance (e.g., ±10%) around the stated numerical values and/or geometry.

The terminology used herein is for the purpose of describing particular embodiments only and is not to be limiting of the embodiments. The singular forms "a," "an," and "the" are intended to include the plural forms as well, unless the context clearly indicates otherwise. It will be further understood that the terms "comprises/comprising" and/or "includes/including" when used herein, specify the presence of stated features, integers, steps, operations, elements, and/or components, but do not preclude the presence or addition of one or more other features, integers, steps, operations, elements, components and/or groups thereof.

Unless otherwise defined, all terms including technical and scientific terms used herein have the same meaning as commonly understood by one of ordinary skill in the art to which the embodiments belong. It will be further understood that terms, such as those defined in commonly-used dictionaries, should be interpreted as having a meaning that is consistent with their meaning in the context of the relevant art and will not be interpreted in an idealized or overly formal sense unless expressly so defined herein.

When describing the embodiments with reference to the accompanying drawings, like reference numerals refer to like components and a repeated description related thereto will be omitted. In the description of embodiments, detailed description of well-known related structures or functions will be omitted when it is deemed that such description will cause ambiguous interpretation of the present disclosure. In addition, the terms first, second, A, B, (a), and (b) may be used to describe constituent elements of the embodiments. These terms are used only for the purpose of discriminating one component from another component, and the nature, the sequences, or the orders of the components are not limited by the terms. It should be noted that if it is described that one component is "connected", "coupled", or "joined" to another component, a third component may be "connected", "coupled", and "joined" between the first and second components, although the first component may be directly connected, coupled, or joined to the second component. It will also be understood that such spatially relative terms, such as "above," "top," "vertical," "lateral," etc., are intended to encompass different orientations of the device in use or operation in addition to the orientation depicted in the figures, and that the device may be otherwise oriented (rotated 90 degrees or at other orientations) and the spatially relative terms used herein interpreted accordingly.

A component, which has the same common function as a component included in any one embodiment, will be described by using the same name in other embodiments. Unless disclosed to the contrary, the description of any one embodiment may be applied to other embodiments, and the specific description of the repeated configuration will be omitted.

A gate stack including dual dipoles is utilized to effectively control an operating voltage in a n-channel metal-oxide semiconductor (nMOS) and a p-channel MOS (pMOS) field effect transistor (FET). For this purpose, when an individual dipole material layer is formed, a titanium (Ti) precursor (e.g., TiCl₄) may be used as an atomic layer deposition (ALD) source material, and when a lanthanum (La)-based material is used as a dipole material, LaCl may be formed and this may cause gate leakage (Jg) deterioration. Accordingly, the present disclosure proposes an n/p MOS gate stack and a method of manufacturing the same that improve Jg during the manufacturing process while maintaining and utilizing the characteristics of the dipole material.

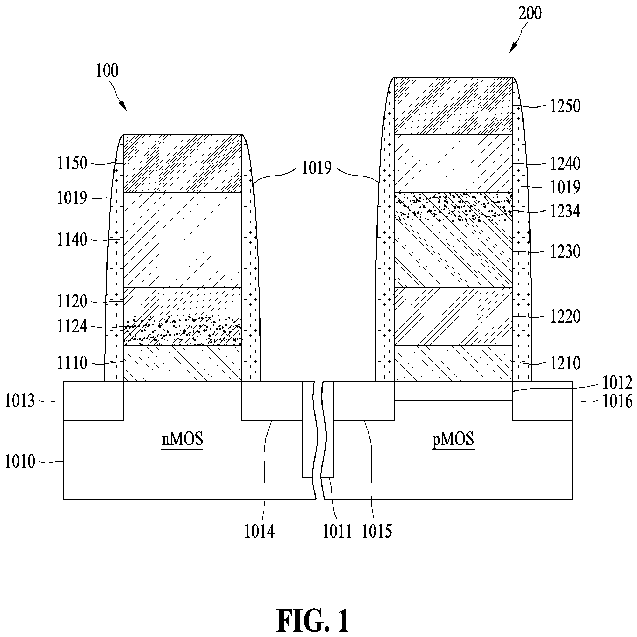

Hereinafter, although it is not limited thereto, the configuration of the n/p MOS gate stack of the present disclosure will be described with reference to FIG. 1 as at least one embodiment.

An n/p MOS gate stack includes a semiconductor substrate 1010, an nMOS stack 100, and a pMOS stack 200. The semiconductor substrate 1010 may have an nMOS region and a pMOS region; the nMOS stack 100 may be formed in the nMOS region and may include a first interface layer 1110, a first high dielectric layer 1120 formed on the first interface layer 1110, a first n-metal layer 1140 formed on the first high dielectric layer 1120, and a first upper electrode 1150 formed on the first n-metal layer 1140. The pMOS stack 200 may be formed in the pMOS region and may include a second interface layer 1210, a second high dielectric layer 1220 formed on the second interface layer 1210, a second p-metal layer 1230 formed on the second high dielectric layer 1220, a second n-metal layer 1240 formed on the second p-metal layer 1230, and a second upper electrode 1250 formed on the second n-metal layer 1240. The first high dielectric layer 1120 includes a first dipole material 1124, and the second p-metal layer 1230 includes a second dipole material 1234.

As shown in FIG. 1, as an example, the semiconductor substrate 1010 may include a device isolation region 1011 that separates the nMOS region and the pMOS region, a first source 1013 and a first drain 1014 of the nMOS region, and a second source 1015 and a second drain 1016 of the pMOS region, and the pMOS region may include a silicon-germanium epitaxial layer 1012. However, this is merely an example configuration of a silicon-based substrate and the n/p MOS gate stack of the present disclosure is not limited thereto. In FIG. 1 and the drawings below, the nMOS region and the pMOS region are shown as separated. The portions expressed separately refer to two regions may be adjacent to each other or spaced apart from each other. In particular, when the regions are adjacent to each other, the regions may be separated by the device isolation region 1011.

The n/p MOS gate stack of the present disclosure may include the semiconductor substrate 1010 having the nMOS region and the pMOS region which are insulated from each other, the nMOS stack 100 formed in the nMOS region on the semiconductor substrate 1010, and the pMOS stack 200 formed in the pMOS region on the semiconductor substrate 1010. The first interface layer 1110, the first high dielectric layer 1120, the first n-metal layer 1140, and the first upper electrode 1150 may be stacked in the nMOS stack 100, the second interface layer 1210, the second high dielectric layer 1220, the second p-metal layer 1230, the second n-metal layer 1240, and the second upper electrode 1250 may be stacked in the pMOS stack 200, and the first high dielectric layer 1120 and the second p-metal layer 1230 may contain the first and second dipole materials 1124 and 1234, respectively.

In a comparative example, when a dipole material is provided in the form of a LaO thin film, in a process of depositing an n-metal layer after LaO deposition in the nMOS region, La in a LaO deposition layer may react with Cl in the n-metal layer deposition process to form LaCl, and in a process of depositing an n-metal layer after depositing LaO on a p-metal layer in the pMOS region, La in a LaO deposition layer may react with Cl in the n-metal layer deposition process to form LaCl, and gate leakage (Jg) deterioration may occur due to LaCl formation. Accordingly, in the present disclosure, in order to prevent (or mitigate) the dipole material from participating in undesired reactions in a subsequent process, the formation of the dipole material may not be allowed to form (or hindered from forming) a layer on an outer surface so that the diffusion of the dipole material into the high dielectric layer in a case of the nMOS region and the diffusion into the p-metal layer in a case of the pMOS region may be prevented and/or mitigated. Additionally a low-chlorine (low-Cl) process may be ensured as the subsequent process for the dipole material introduction process.

Specifically, the first dipole material 1124 in the nMOS region is diffused into the first high dielectric layer 1120 and does not exist (e.g., is not detectable) on an (external) upper surface of the first high dielectric layer 1120, so that LaCl may not be formed in the process of depositing the first n-metal layer 1140 which is the subsequent step. The second dipole material 1234 in the pMOS region is diffused into the second p-metal layer 1230 and does not exist (e.g., is not detectable) on an (external) upper surface of the second p-metal layer 1230, so that LaCl may not be formed in the process of depositing the second n-metal layer 1240 which is the subsequent step. In addition, the first n-metal layer 1140 deposition process and the second n-metal layer 1240 deposition process are performed as a low-Cl process, which may further reduce the possibility of LaCl formation.

The first dipole material 1124 of the nMOS region diffused into the first high dielectric layer 1120 may be distributed in an internal area within the first high dielectric layer 1120 to form a layer, and/or may spread evenly inside the first high dielectric layer 1120 and distributed without forming a layer in a certain area. For example, a concentration of the first dipole material 1124 may be constant within a certain area, and/or may change with distance from the upper surface of the first interface layer 1110. In the present disclosure, the fact that the first high dielectric layer 1120 includes the first dipole material 1124 implies that it includes both of these cases unless expressly indicated otherwise.

The second dipole material 1234 of the pMOS region diffused into the second p-metal layer 1230 may be distributed in a certain area within the second p-metal layer 1230 to form a layer, or may spread evenly inside the second p-metal layer 1230 and distributed without forming a layer in a certain area. In the present disclosure, the fact that the second p-metal layer 1230 includes the second dipole material 1234 implies that it includes both of these cases unless expressly indicated otherwise.

According to an aspect of the present disclosure, the first interface layer 1110 and the second interface layer 1210 each may include at least one of SiO₂ or SiON. The first high dielectric layer 1120 and the second high dielectric layer 1220 may include a high-k material. For example, the first high dielectric layer 1120 and the second high dielectric layer 1220 each may include at least one of HfO, HfSiO, and HfSiON, and the first n-metal layer 1140, the second n-metal layer 1240, and the second p-metal layer 1230 each may include at least one of TiN, TiO₂, TiON, TiSiN, TiAl, and TiAlN.

In the process of forming the first n-metal layer 1140, the second n-metal layer 1240, and the second p-metal layer 1230, a Ti precursor TiCl₄ may be used as a Ti providing source, thereby increasing the possibility of LaCl formation. Therefore, in the present disclosure, it is proposed to introduce the dipole material not to be exposed such that the LaCl is not formed in the deposition process, which is the subsequent step, and to perform second p-metal layer formation, first n-metal layer formation, and second n-metal layer formation process through the low-Cl process.

According to an aspect of the present disclosure, the first dipole material may include La₂O₃, and as shown in FIG. 1, the first dipole material 1124 may be diffused in the first high dielectric layer 1120.

In the present disclosure, in the nMOS region, in order to prevent (or reduce) the first dipole material 1124 from coming into contact with Cl and causing undesired reactions to form LaCl in the subsequent process, the first dipole material 1124 is diffused into the first high dielectric layer 1120. As one example of the method, the first dipole material 1124 may be diffused to the first high dielectric layer 1120 through a heat treatment, and depending on the degree of heat treatment, the first dipole material 1124 may be placed mainly on an upper end portion of the first high dielectric layer 1120, or the first dipole material 1124 may be sufficiently diffused to the first high dielectric layer 1120. When it is sufficiently diffused into the first high dielectric layer 1120 by the heat treatment of a certain degree or more, the first dipole material 1124 may be distributed evenly throughout the first high dielectric layer 1120, or the first dipole material 1124 may be more concentrated in a portion below the middle of the first high dielectric layer 1120, that is, near an interface with the first interface layer 1110 through sufficient heat treatment. That is, the distribution form and position of the first dipole material 1124 in the first high dielectric layer 1120 may be controlled by heat treatment conditions (a temperature and a time).

Although not limited thereto, as shown in FIG. 1, according to an aspect of the present disclosure, the first dipole material 1124 diffused to the first high dielectric layer 1120 may be diffused to the interface between the first high dielectric layer 1120 and the first interface layer 1110.

Although described in detail in a method of manufacturing the n/p MOS gate stack of the present disclosure, when the first dipole thin film is formed on the first high dielectric layer 1120 and the dipole material of the first dipole thin film is diffused into the first high dielectric layer 1120 below the dipole material by a heat treatment, the diffusion continues as the heat treatment time is maintained, and the diffusion progresses from an upper end portion to a lower end portion in the first high dielectric layer 1120. As the heat treatment time is maintained, the diffused first dipole material 1124 may diffuse to the lower end portion of the first high dielectric layer 1120, as shown in FIG. 1. The heat treatment may be performed in the nMOS region and the pMOS region simultaneously (e.g., in the same time period). Accordingly, due to a difference between a diffusion rate of the first dipole material 1124 into and/or in the first high dielectric layer 1120 in the nMOS region and a diffusion rate of the second dipole material 1234 into and/or in the second p-metal layer 1230 in the pMOS region, a position of the first dipole material 1124 inside the first high dielectric layer 1120 and a position of the second dipole material 1234 within the second p-metal layer 1230 may be different. For example, when the diffusion rate of the first dipole material 1124 into the first high dielectric layer 1120 in the nMOS region is faster than the diffusion rate of the second dipole material 1234 into the second p-metal layer 1230 in the pMOS region, as shown in FIG. 1, the first dipole material 1124 in the nMOS region may be diffused to a lower end portion inside the first high dielectric layer 1120, and the second dipole material 1234 in the pMOS region may be diffused only to an upper end portion inside the second p-metal layer 1230.

According to an aspect of the present disclosure, the second dipole material 1234 may include La₂O₃, and the second dipole material 1234 may form a thin film region on the upper end portion of the second p-metal layer 1230, and/or may be diffused to the second p-metal layer 1230.

In the present disclosure, in the pMOS region, in order to prevent the second dipole material 1234 from coming into contact with Cl and causing undesired reactions to form LaCl in the subsequent process, the second dipole material 1234 is diffused into the second p-metal layer 1230. As one example of the method, the second dipole material 1234 may be diffused into the second p-metal layer 1230 through the heat treatment, and depending on the degree of heat treatment, a position of the second dipole material 1234 in the second p-metal layer 1230 may also be controlled. By sufficiently performing the heat treatment, the second dipole material 1234 may be sufficiently diffused into the second high dielectric layer so that the second dipole material 1234 is evenly distributed throughout the second p-metal layer 1230. That is, the distribution form and position of the second dipole material 1234 in the second p-metal layer 1230 may be controlled through heat treatment conditions (a temperature and a time).

When the second dipole material 1234 exists on the second p-metal layer 1230, the second dipole material 1234 may form LaCl by coming into contact with Cl and causing undesired reactions in the subsequent process. Thus, the amount of the second dipole material 1234 existing on the second p-metal layer 1230 due to the diffusion into the second p-metal layer 1230 is minimized.

The second dipole material 1234 forming a thin film region at the upper end portion of the second p-metal layer 1230 does not refer to the formation of a separate thin film to be exposed to the outside on the second p-metal layer 1230, but may refer to the second dipole material 1234 that exists in the second p-metal layer 1230 but is positioned in a portion (region) with a predetermined width in a film-like structure. That is, the thin film region may refer to a region (section) existing in the second p-metal layer 1230.

Although not limited thereto, as shown in FIG. 1, the second dipole material 1234 diffused into the second p-metal layer 1230 may be diffused (mainly) into the upper end portion of the second p-metal layer 1230.

By forming a second dipole thin film on the second p-metal layer 1230 and performing the heat treatment, the dipole material of the second dipole thin film is diffused into the second p-metal layer 1230 below. Since the diffusion progresses from the upper end portion to the lower end portion of the second p-metal layer 1230, the second dipole material 1234 may be diffused into the second p-metal layer 1230 as the heat treatment time is maintained. The heat treatment may be performed in the nMOS region and the pMOS region simultaneously (during the same time). Accordingly, due to a difference between the diffusion rate of the first dipole material 1124 into the first high dielectric layer 1120 in the nMOS region and the diffusion rate of the second dipole material 1234 into the second p-metal layer 1230 in the pMOS region, the position of the first dipole material 1124 inside the first high dielectric layer 1120 and the position of the second dipole material 1234 within the second p-metal layer 1230 may be different. For example, when the diffusion rate of the first dipole material 1124 into the first high dielectric layer 1120 in the nMOS region is faster than the diffusion rate of the second dipole material 1234 into the second p-metal layer 1230 in the pMOS region, as shown in FIG. 1, the first dipole material 1124 in the nMOS region may be diffused to a lower end portion inside the first high dielectric layer 1120, and the second dipole material 1234 in the pMOS region may be diffused only to an upper end portion inside the second p-metal layer 1230.

Although it is not limited thereto, as shown in FIG. 1 as an example, a diffusion concentration of the second dipole material 1234 in the upper end portion of the second p-metal layer 1230 (a concentration of the second dipole material existing in the region due to the diffusion) may be greater than a diffusion concentration of the second dipole material 1234 in the lower end portion of the second p-metal layer 1230.

From the thin film containing the second dipole material 1234 formed on the second p-metal layer 1230, the second dipole material 1234 is diffused into the second p-metal layer 1230 through the heat treatment process. Since the diffusion rate of the second dipole material 1234 within the second p-metal layer 1230 is not fast (e.g., is slower than the diffusion of the first dipole material 1124 within the first high dielectric layer 1120), the second dipole material 1234 may be diffused into the upper end portion of the second p-metal layer 1230 during the heat treatment process, but the second dipole material 1234 may not have diffused into the lower end portion of the second p-metal layer 1230. As a result, as shown in FIG. 1 as an example, the second dipole material 1234 diffused into the second p-metal layer 1230 may be mainly distributed at the upper end portion of the second p-metal layer 1230.

According to an aspect of the present disclosure, a thickness of the second p-metal layer is 10 Å to 100 Å, and a Cl concentration in the second p-metal layer may be more than 0% by weight and 5% by weight or less.

The thickness of the second p-metal layer may be determined according to the specifications of the entire n/p MOS gate stack. Here, when the thickness of the second p-metal layer is less than 10 Å, the second dipole material may be diffused into the second high dielectric layer during the diffusion process, and when the thickness of the second p-metal layer is greater than 100 Å, the thickness of the entire n/p MOS gate stack may be increased and the process time may be increased.

Since La reacts with Cl to form LaCl and gate leakage (Jg) deterioration may occur, the process of forming the second p-metal layer and the process of forming the second n-metal layer after diffusing the second dipole material may be performed with a low-Cl reaction. The Cl concentration in the second p-metal layer may ideally be 0 (.e.g., a state without Cl), and/or more than 0% by weight and 5% by weight or less (e.g., within a range of 0% to 5% by weight). In order to lower the Cl concentration in the second p-metal layer, after the diffusion of the second dipole material into the second p-metal layer, the second dipole thin film remaining on the second p-metal layer may be stripped (peeled off) with a HCl solution, etc.

According to an aspect of the present disclosure, an interface between the first high dielectric layer 1120 and the first n-metal layer 1140 and an interface between the second p-metal layer 1230 and the second n-metal layer 1240 may be LaCl-free.

In the nMOS region, the first dipole material 1124 may be diffused into the first high dielectric layer 1120 such that no first dipole material 1124 remains on the first high dielectric layer 1120, that is, outside the first high dielectric layer 1120. Accordingly, LaCl may not exist (e.g., may be undetectable) at the interface between the first high dielectric layer 1120 and the first n-metal layer 1140. This may indicate that, during the process of forming the first n-metal layer 1140 on the first high dielectric layer 1120, La did not react with Cl to form LaCl.

In the pMOS region, the second dipole material 1234 may be diffused into the second p-metal layer 1230 such that no second dipole material remains on the second p-metal layer 1230, that is, outside the second p-metal layer. Accordingly, LaCl may not exist at the interface between the second p-metal layer 1230 and the second n-metal layer 1240. This may indicate that, during the process of forming the second n-metal layer 1240 on the second high dielectric layer 1220, La did not react with Cl to form LaCl.

When La reacts with Cl to form LaCl, the gate leakage (Jg) deterioration may occur. For this, the process of forming the second p-metal layer 1230 and the process of forming the second n-metal layer 1240 after diffusing the second dipole material 1234 may be performed with a low-Cl reaction, the second dipole thin film remaining on the second p-metal layer 1230 may be stripped (peeled off) with a HCl solution, etc. after the diffusion of the second dipole material into the second p-metal layer, and the reaction between La and Cl may be prevented at the interface between the second p-metal layer and the second n-metal layer. Through this, a LaCl-free n/p MOS gate stack may be obtained without LaCl as a reactant. This method may be applied to the interface between the first high dielectric layer 1120 and the first n-metal layer 1140 in the same manner, and this will be described in detail in the method of manufacturing the n/p MOS gate stack.

According to an aspect of the present disclosure, spacers 1019 formed on side surfaces from the interface layers to the upper electrodes at the uppermost ends formed in the nMOS region and the pMOS region may be included.

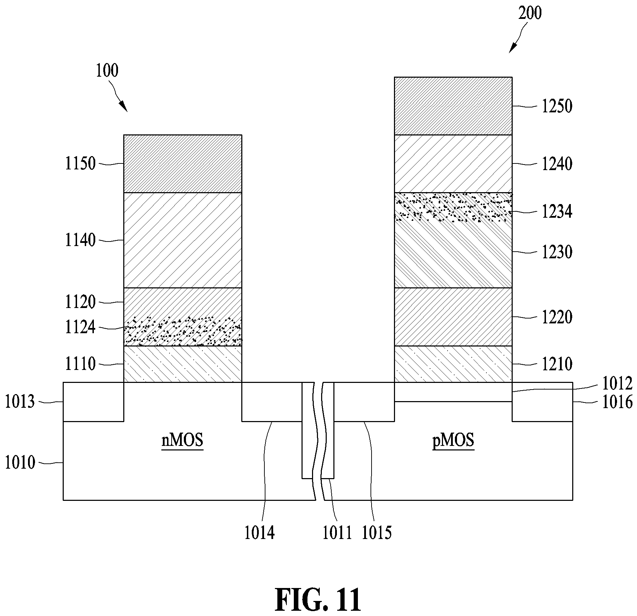

According to an aspect of the present disclosure, the structure of the n/p MOS gate stack may include a planar structure, or one three-dimensional (3D) structure of a recess gate, FinFET, or Gate-All-Around (GAA) transistor. FIG. 11 shows a conceptual diagram of an n/p MOS gate stack including a FinFET 3D structure, as an example. However, this is merely an example of an applicable 3D structure, and the scope of application of the present disclosure is not limited thereto.

A method of manufacturing the n/p MOS gate stack of the present disclosure includes preparing the semiconductor substrate 1010, forming the first interface layer 1110 and the second interface layer 1210 in an nMOS region and a pMOS region of the semiconductor substrate 1010, respectively, forming the first high dielectric layer 1120 and the second high dielectric layer 1220 on the first interface layer 1110 and the second interface layer 1210, respectively, forming the first p-metal layer 1130 and the second p-metal layer 1230 on the first high dielectric layer 1120 and the second high dielectric layer 1220, respectively, exposing the first high dielectric layer 1120 by removing the first p-metal layer 1130 formed on the first high dielectric layer 1120, forming a first dipole thin film 1122 and a second dipole thin film 1232 on the exposed first high dielectric layer 1120 and the second p-metal layer 1230, respectively, performing heat treatment on the first dipole thin film 1122 and the second dipole thin film 1232, exposing the first high dielectric layer 1120 and the second p-metal layer 1230 by removing a residue of the first dipole thin film 1122 and a residue of the second dipole thin film 1232, forming the first n-metal layer 1140 and the second n-metal layer 1240 on the exposed first high dielectric layer 1120 and the exposed second p-metal layer 1230, respectively; and forming the first upper electrode 1150 and the second upper electrode 1250 on the first n-metal layer 1140 and the second n-metal layer 1240, respectively.

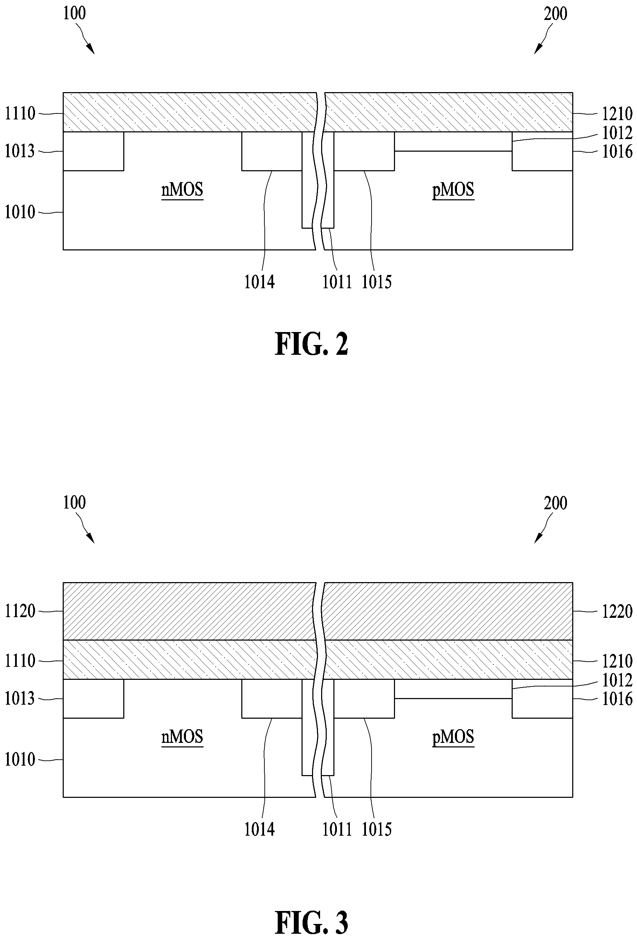

Hereinafter, although it is not limited thereto, the method of manufacturing the n/p MOS gate stack of the present disclosure will be described with reference to FIGS. 2 to 11 as an example.

FIG. 2 illustrates a conceptual diagram of an operation of forming the first interface layer 1110 and the second interface layer 1210, respectively, in the nMOS region and the pMOS region of the n/p MOS gate stack, according to at least one embodiment.

The first interface layer 1110 and the second interface layer 1210 may include SiO₂ and/or SiON, and may include the same components when formed simultaneously, but the present disclosure is not limited thereto. In addition, for the method of forming the first interface layer 1110 and the second interface layer 1210, a general formation method of the n/p MOS gate stack or a method of forming a micro pattern may be applied and the method is not limited to a specific formation method.

According to an aspect of the present disclosure, in addition to the first interface layer 1110 and the second interface layer 1210, the first high dielectric layer 1120, the second high dielectric layer 1220, the first p-metal layer 1130, the second p-metal layer 1230, the first dipole thin film 1122, the second dipole thin film 1232, the first n-metal layer 1140, and the second n-metal layer 1240 may each be formed by a deposition or an atomic layer deposition (ALD) method. The layers that are formed simultaneously may be formed by the same method, and the layers that are not formed simultaneously may be formed by the same method or different methods.

FIG. 3 illustrates a conceptual diagram of an operation of forming the first high dielectric layer 1120 and the second high dielectric layer 1220, respectively, on the first interface layer 1110 and the second interface layer 1210 of the n/p MOS gate stack, according to at least one embodiment.

The first high dielectric layer 1120 and the second high dielectric layer 1220 may include at least one of HfO, HfSiO, and HfSiON, and may include the same component when formed simultaneously. However, the present disclosure is not limited thereto. In addition, for the method of forming the first high dielectric layer 1120 and the second high dielectric layer 1220, a general formation method of the n/p MOS gate stack or a method of forming a micro pattern may be applied and the method is not limited to a specific formation method.

In at least some embodiments, the first high dielectric layer 1120 and the second high dielectric layer 1220 may have a thickness of more than 0 Å and 30 Å or less.

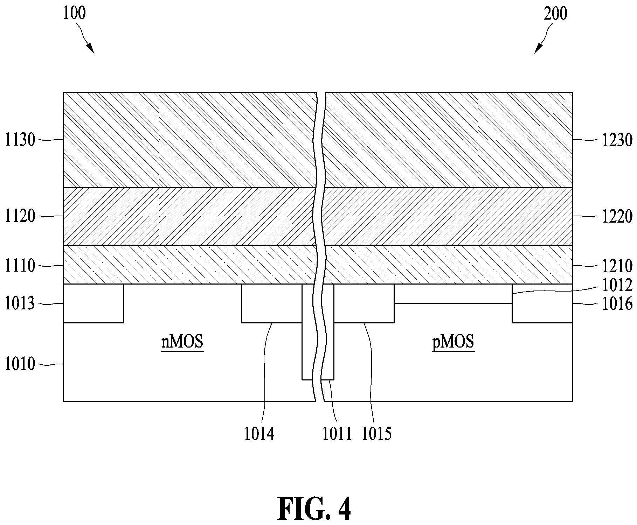

FIG. 4 illustrates a conceptual diagram of an operation of forming the first p-metal layer 1130 and the second p-metal layer 1230 respectively on the first high dielectric layer 1120 and the second high dielectric layer 1220 according to at least one embodiment.

The first p-metal layer 1130 and the second p-metal layer 1230 may include at least one of TiN, TiO₂, TiON, TiSiN, TiAl, and TiAlN, and may include the same component when formed simultaneously. However, the present disclosure is not limited thereto. In addition, for the method of forming the first p-metal layer 1130 and the second p-metal layer 1230, a general formation method of the n/p MOS gate stack or a method of forming a micro pattern may be applied and the method is not limited to a specific formation method.

According to an aspect of the present disclosure, the operation of forming the first p-metal layer 1130, the second p-metal layer 1230, the first n-metal layer 1140, and the second n-metal layer 1240 may be performed under H₂, N₂, NH₃, SiH₄, and dichlorosilane atmospheres.

The formation methods of the first p-metal layer 1130 and the second p-metal layer 1230 are not limited thereto, but the first p-metal layer 1130 and the second p-metal layer 1230 may be formed by ALD, and in this case, TiCl₄ may be used as a Ti precursor, which is a Ti providing source. There is a possibility that Cl decomposed from Ti reacts with La of a dipole material to be provided later and LaCl is formed (gate leakage (Jg) deterioration occurs). Therefore, the present disclosure proposes to lower the possibility of formation of LaCl in a subsequent process by forming the second p-metal layer 1230 with a low-Cl process, in addition to lowering the possibility of formation of LaCl by diffusing the dipole material into the second p-metal layer 1230 and preventing the dipole material from remaining and being exposed on the second p-metal layer 1230.

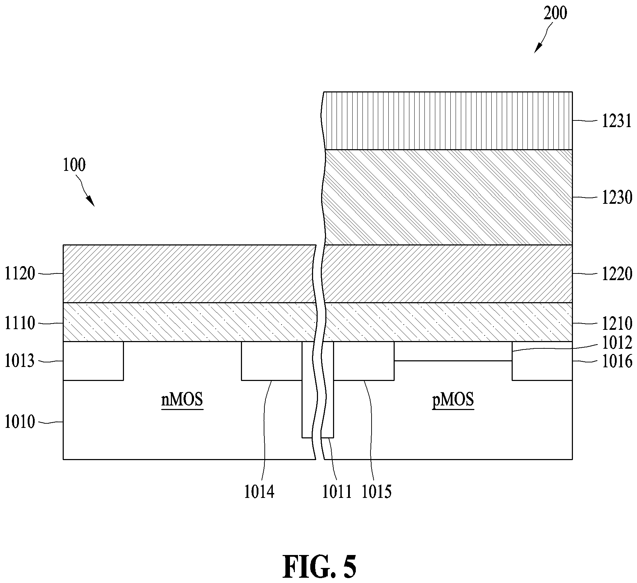

FIG. 5 illustrates a conceptual diagram of an operation of exposing the first high dielectric layer 1120 by removing the first p-metal layer 1130 formed on the first high dielectric layer 1120 according to at least one embodiment.

The first p-metal layer formed on the first high dielectric layer may be removed by patterning through a strip 1231 using a photoresist, a bottom anti-reflection coating (BARC), or both.

FIG. 5 shows a configuration of removing only the first p-metal layer 1130 by masking (patterning a photoresist) the second p-metal layer 1230 as one of the methods of removing only the first p-metal layer 1130, but the present disclosure is not limited thereto.

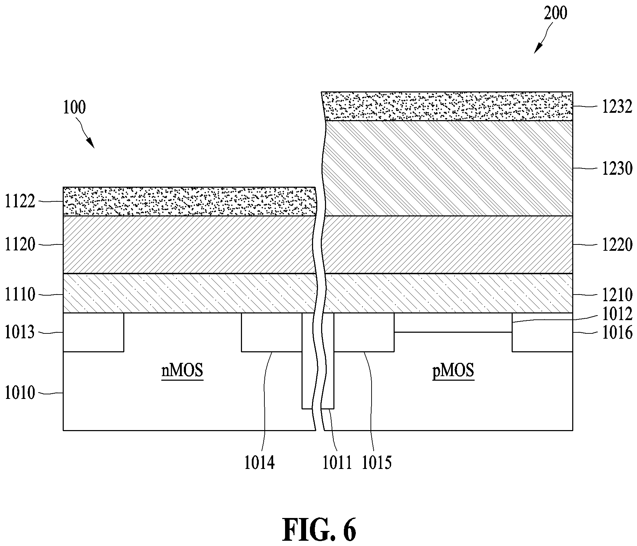

FIG. 6 illustrates a conceptual diagram of an operation of forming the first dipole thin film 1122 and the second dipole thin film 1232 respectively on the exposed first high dielectric layer 1120 and the second p-metal layer 1230 according to at least one embodiment.

The first dipole thin film 1122 and the second dipole thin film 1232 may include La₂O₃ and may include the same component when formed simultaneously. However, the present disclosure is not limited thereto.

According to an aspect of the present disclosure, the first dipole thin film 1122 and the second dipole thin film 1232 may be formed to have a thickness of 1 Å to 50 Å.

When the thickness of the first dipole thin film 1122 and the second dipole thin film 1232 is less than 1 Å, it may be difficult to sufficiently provide a dipole material to be diffused into the first high dielectric layer 1120 and the second p-metal layer 1230, and when the thickness of the first dipole thin film 1122 and the second dipole thin film 1232 is more than 50 Å, it may be necessary to increase a temperature of a subsequent heat treatment process and/or perform the corresponding process longer, which may cause a complicated process of removing a residual thin film after the diffusion.

Therefore, the first dipole thin film 1122 and the second dipole thin film 1232 may be adjusted to have a thickness of 1 Å to 50 Å to control the amount of the dipole material to be diffused to the first high dielectric layer 1120 and the second p-metal layer 1230.

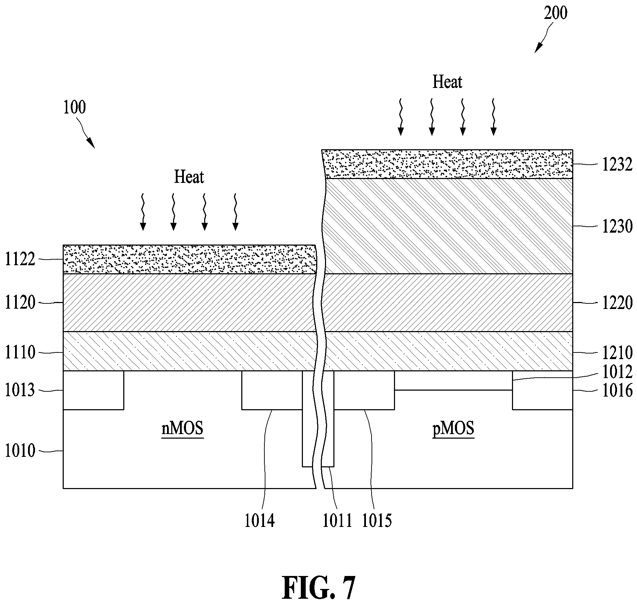

FIG. 7 illustrates a conceptual diagram of an operation of performing a heat treatment on the first dipole thin film 1122 and the second dipole thin film 1232 according to at least one embodiment.

The heat treatment may be performed at 600°C to 1000°C in an inert atmosphere (e.g., a N₂ atmosphere). The heat treatment temperature and time may be adjusted to control the amount of the dipole material to be diffused into the first high dielectric layer 1120 and the second p-metal layer 1230, the position or distribution of the first dipole material 1124 in the first high dielectric layer 1120, and the position or distribution of the second dipole material 1234 in the second p-metal layer 1230.

During the heat treatment process, the dipole material of the second dipole thin film 1232 is diffused into the second p-metal layer 1230 below. As the heat treatment time is long, the diffusion continues and the diffusion progresses from the upper end portion to the lower end portion in the second p-metal layer 1230. Therefore, as the heat treatment time is long, the diffused second dipole material 1234 may be diffused into the second p-metal layer 1230. The heat treatment may be performed in the nMOS region and the pMOS region simultaneously (during the same time). Accordingly, due to a difference between the diffusion rate of the first dipole material 1124 into the first high dielectric layer 1120 in the nMOS region and the diffusion rate of the second dipole material 1234 into the second p-metal layer 1230 in the pMOS region, the position or distribution of the first dipole material 1124 inside the first high dielectric layer 1120 and the position or distribution of the second dipole material 1234 within the second p-metal layer 1230 may be different. For example, when the diffusion rate of the first dipole material 1124 into the first high dielectric layer 1120 in the nMOS region is faster than the diffusion rate of the second dipole material 1234 into the second p-metal layer 1230 in the pMOS region, as shown in FIG. 1, the first dipole material 1124 in the nMOS region may be diffused into the lower end portion inside the first high dielectric layer 1120, and the second dipole material 1234 in the pMOS region may be diffused only into the upper end portion inside the second p-metal layer 1230.

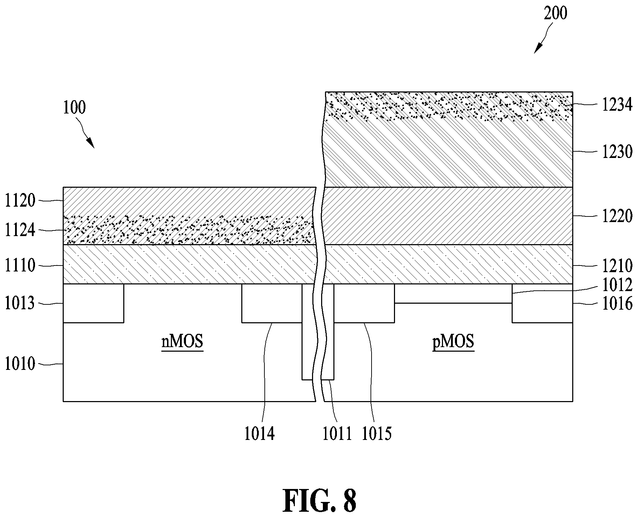

FIG. 8 illustrates a conceptual diagram of an operation of exposing the first high dielectric layer 1120 and the second p-metal layer 1230 by removing a residue of the first dipole thin film 1122 and a residue of the second dipole thin film 1232 according to at least one embodiment.

The residue of the first dipole thin film 1122 and the residue of the second dipole thin film 1232 are removed not only to expose the first high dielectric layer 1120 and the second p-metal layer 1230, but also to ensure that the dipole materials do not remain on the first high dielectric layer 1120 and the second p-metal layer 1230, except for the dipole materials diffused into the first high dielectric layer 1120 and the second p-metal layer 1230. When there are residual dipole materials on the first high dielectric layer 1120 and the second p-metal layer 1230, the La component of the dipole material may react with Cl in the process to form LaCl. Accordingly, it is beneficial to ensure that there is no residual dipole material on the first high dielectric layer 1120 and the second p-metal layer 1230. For this, the present disclosure proposes to not only remove the residue of the first dipole thin film 1122 and the residue of the second dipole thin film 1232, but also to lower the possibility of forming LaCl by performing the formation of the second p-metal layer 1230, the first n-metal layer 1140, and the second n-metal layer 1240 with the low-Cl process.

According to an aspect of the present disclosure, the residue of the first dipole thin film and the residue of the second dipole thin film may be removed by HCl wet etching. However, this is proposed as an example, and any method may be applied without limitation as long as it is a method of effectively removing the residue of the first dipole thin film 1122 and the residue of the second dipole thin film 1232 respectively on the first high dielectric layer 1120 and the second p-metal layer 1230.

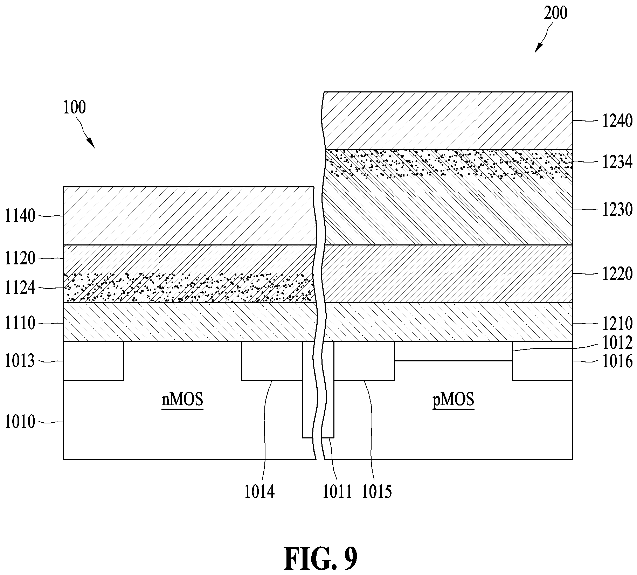

FIG. 9 illustrates a conceptual diagram of an operation of forming the first n-metal layer 1140 and the second n-metal layer 1240 respectively on the exposed first high dielectric layer 1120 and the exposed second p-metal layer 1230 according to at least one embodiment.

While embodiments of the disclosure are not limited thereto, the first n-metal layer 1140 and the second n-metal layer 1240 may be formed by ALD, and in this case, TiCl₄ may be used as a Ti precursor, which is a Ti providing source. There is a possibility that Cl decomposed from Ti reacts with La of a dipole material to be provided later and LaCl is formed (gate leakage (Jg) deterioration occurs). Therefore, the present disclosure proposes to form the first n-metal layer 1140 and the second n-metal layer 1240 with the low-Cl process to lower the possibility of formation of LaCl in the corresponding process, in addition to lowering the possibility of formation of LaCl by diffusing the dipole material as an example into the first high dielectric layer 1120 and the second p-metal layer 1230 and preventing the dipole material from remaining and being exposed on the first high dielectric layer 1120 and the second p-metal layer 1230.

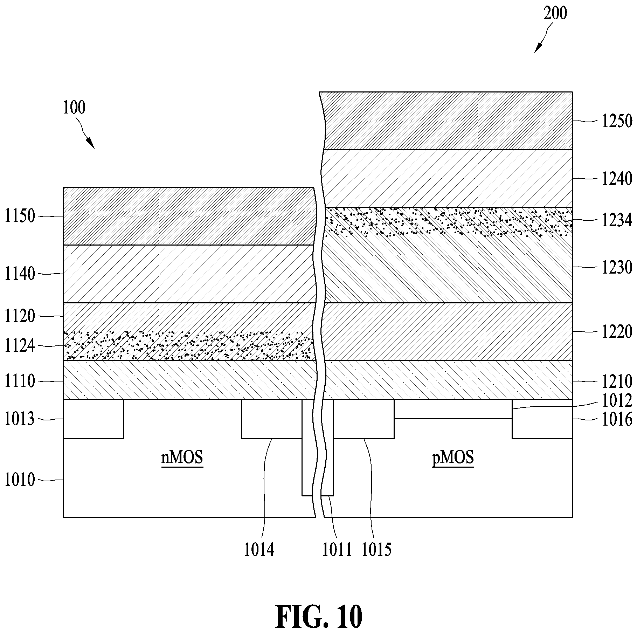

FIG. 10 illustrates a conceptual diagram of an operation of forming the first upper electrode 1150 and the second upper electrode 1250 respectively on the first n-metal layer 1140 and the second n-metal layer 1240 according to at least one embodiment.

According to at least one embodiment of the present disclosure, the first upper electrode 1150 and the second upper electrode 1250 may include polysilicon, and may be respectively formed by deposition or the ALD method. However, embodiments of the present disclosure are not limited thereto. When the first upper electrode 1150 and the second upper electrode 1250 are formed simultaneously, they may be formed by the same method, but when they are not formed simultaneously, they may be formed by the same method or by different methods.

FIG. 11 illustrates that the nMOS stack 100 and the pMOS stack 200 are formed in the nMOS region and the pMOS region, respectively. The spacers 1019 (see FIG. 1) are formed on the side surface of the nMOS stack 100 and the pMOS stack 200 formed as described above to obtain the n/p MOS gate stack according to at least one embodiment of the present disclosure shown in FIG. 1.

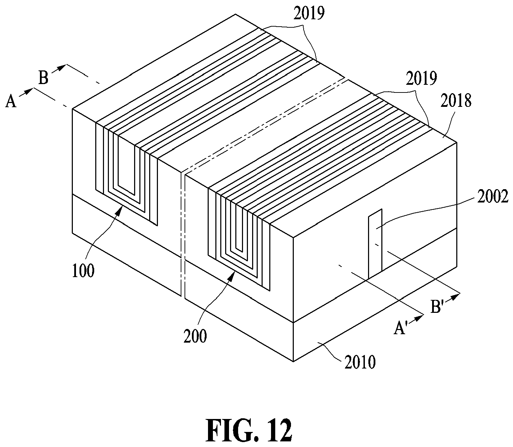

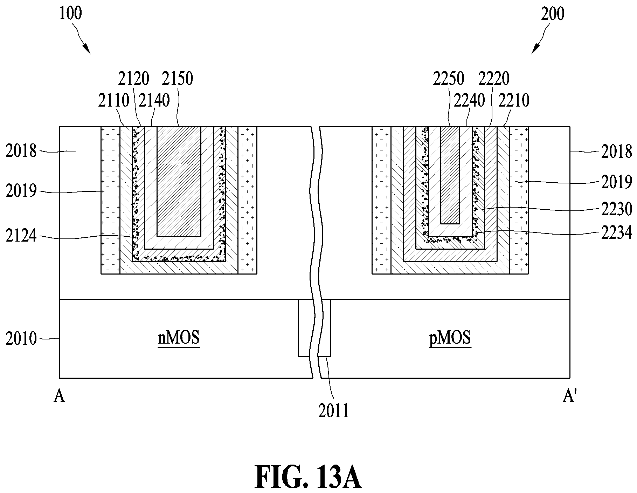

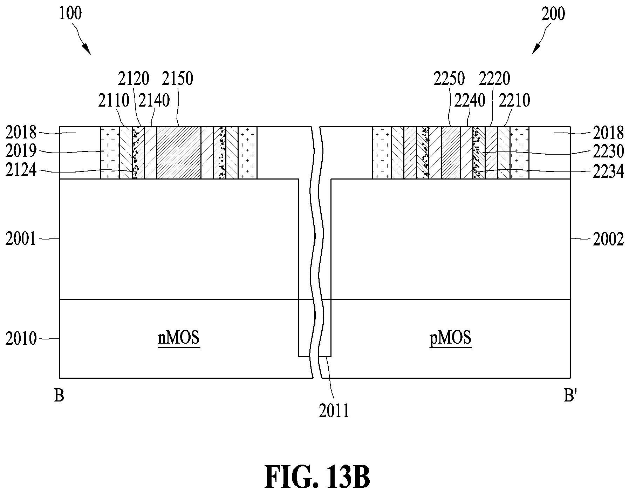

FIG. 12 illustrates a perspective view of an n/p MOS gate stack having a 3D FinFET structure formed on a substrate 2010 according to at least one embodiment, and FIGS. 13A and 13B illustrate cross-sectional views of an n/p MOS gate stack having a 3D FinFET structure taken along lines A-A' and B-B' of FIG. 12, respectively.

The present disclosure is not limited thereto, and the structure of the n/p MOS gate stack may be formed in various ways depending on the manufacturing method. The 3D FinFET structure has a structure that may reduce short channel effects. The 3D FinFET structure may include an active region with a 3D fin shape with source/drain regions on both sides of a channel region. The channel region may be surrounded by a gate electrode. A 3D channel may be formed along a surface of the fin. Since the channel is formed on a top surface and side walls of the fin, the 3D FinFET structure may have a comparatively effective channel width in a relatively small horizontal area (e.g., compared to a planar MOSFET). The 3D FinFET structure may have relatively smaller size and faster operating speed than the planar MOSFET with a similar size of the related art. Unless expressly indicated otherwise, the composition of the first interface layer 2110, the first high dielectric layer 2120, the first n-metal layer 2140, the first fill metal layer 2150, the second interface layer 2210, the second high dielectric layer 2220, the second p-metal layer 2230, the second n-metal layer 2240, the second fill metal layer 2250 and/or the spacer 2019 may, respectively, be the same as and/or substantially similar to the composition of the first interface layer 1110, the first high dielectric layer 1120, the first n-metal layer 1140, the first upper electrode 1150, the second interface layer 1210, the second high dielectric layer 1220, the second p-metal layer 1230, the second n-metal layer 1240, the second upper electrode 1250 and/or the spacer 1019 described above.

As shown in FIG. 13A, spacers 2019 may be formed between the side surfaces of the nMOS stack 100 and the pMOS stack 200 formed on the substrate 2010 and an insulating layer 2018. FIG. 13B shows a cross-sectional view of a portion including a source/drain along line B-B' in FIG. 12, and thus shows a first source/drain 2001 in the nMOS region and a second source/drain 2002 in the pMOS region. Both regions may be separated by a device isolation region 2011 and the insulating layer 2018.

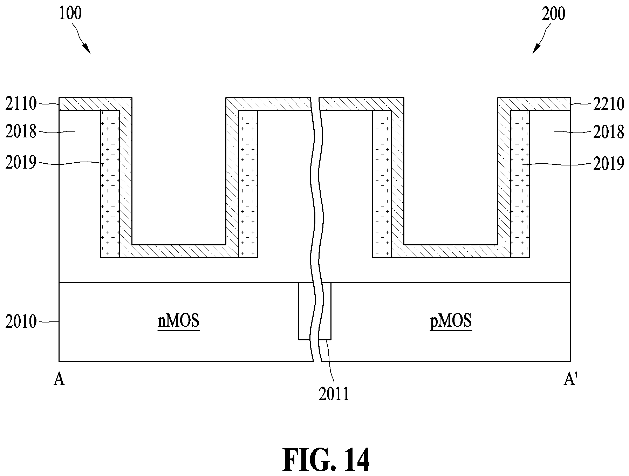

FIGS. 14 to 23 illustrate conceptual diagrams of an operation of manufacturing an n/p MOS gate stack having a 3D FinFET structure according to at least one embodiment. FIGS. 14 to 23 illustrate cross-sectional views taken along line A-A' of FIG. 12 to describe a process of forming each layer. Referring to FIGS. 14 to 23, an operation of manufacturing an n/p MOS gate stack having a 3D FinFET structure according to at least one embodiment will be described.

FIG. 14 illustrates a conceptual diagram of an operation of forming a first interface layer 2110 and a second interface layer 2210 in the nMOS region and the pMOS region of the n/p MOS gate stack according to at least one embodiment.

The insulating layer 2018 may be used to form a space (a pattern) in which the nMOS stack 100 and the pMOS stack 200 is to be formed in the nMOS region and the pMOS region, and a spacer 2019 may be formed on the side surface of each region. First, the first interface layer 2110 and the second interface layer 2210 are formed. The first interface layer 2110 and the second interface layer 2210 may be formed through one deposition process.

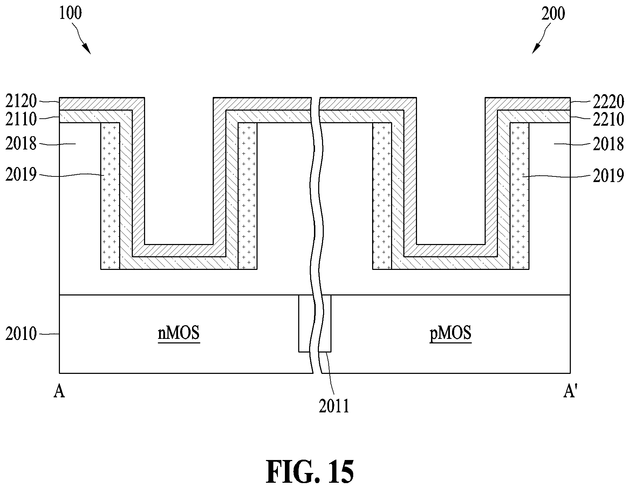

FIG. 15 illustrates a conceptual diagram of an operation of forming a first high dielectric layer 2120 and a second high dielectric layer 2220 along the surfaces of the first interface layer 2110 and the second interface layer 2210 according to at least one embodiment. The first high dielectric layer 2120 and the second high dielectric layer 2220 may also be formed by one process.

In addition, for the method of forming the first high dielectric layer 2120 and the second high dielectric layer 2220, a general formation method of the n/p MOS gate stack or a method of forming a micro pattern may be applied and the method is not limited to a specific formation method.

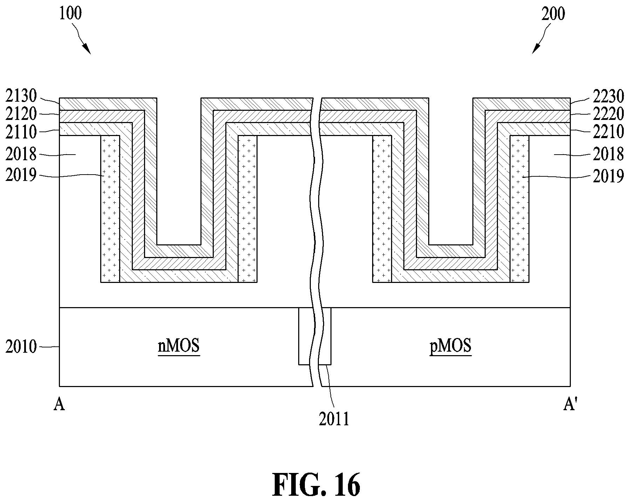

FIG. 16 illustrates a conceptual diagram of an operation of forming a first p-metal layer 2130 and a second p-metal layer 2230 respectively on the first high dielectric layer 2120 and the second high dielectric layer 2220 according to at least one embodiment. The first p-metal layer 2130 and the second p-metal layer 2230 may also be formed as one layer.

In addition, for the method of forming the first p-metal layer 2130 and the second p-metal layer 2230, a general formation method of the n/p MOS gate stack or a method of forming a micro pattern may be applied and the method is not limited to a specific formation method.

According to an aspect of the present disclosure, the operation of forming the first p-metal layer 2130 and the second p-metal layer 2230 may be performed under H₂, N₂, NH₃, SiH₄ and dichlorosilane gas atmospheres.

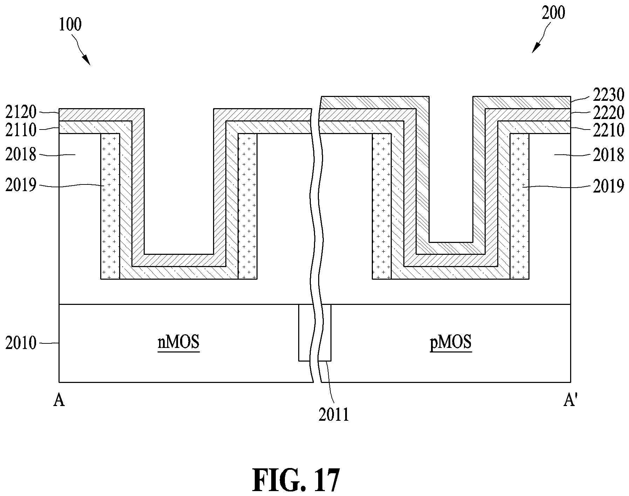

FIG. 17 illustrates a conceptual diagram of an operation of exposing the first high dielectric layer 2120 by removing the first p-metal layer 2130 formed on the first high dielectric layer 2120 according to at least one embodiment.

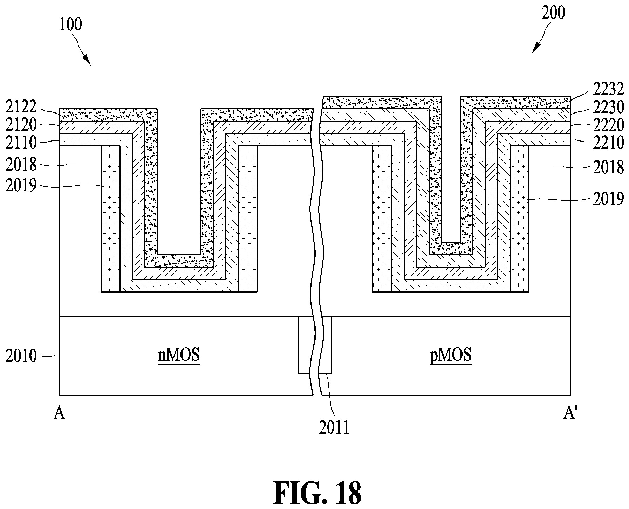

FIG. 18 illustrates a conceptual diagram of an operation of forming a first dipole thin film 2122 and a second dipole thin film 2232 respectively on the exposed first high dielectric layer 2120 and the second p-metal layer 2230 according to at least one embodiment. The first dipole thin film 2122 and the second dipole thin film 2232 may be formed as one layer, and the exposed first high dielectric layer 2120 and the second p-metal layer 2230 have a step. Accordingly, the first dipole thin film 2122 and the second dipole thin film 2232 may also be formed with the step. The first dipole thin film 2122 and the second dipole thin film 2232 may include La₂O₃.

The thicknesses of the first dipole thin film 2122 and the second dipole thin film 2232 may be adjusted to control the amount of dipole materials 2124 and 2234 to be diffused to the first high dielectric layer 2120 and the second p-metal layer 2230.

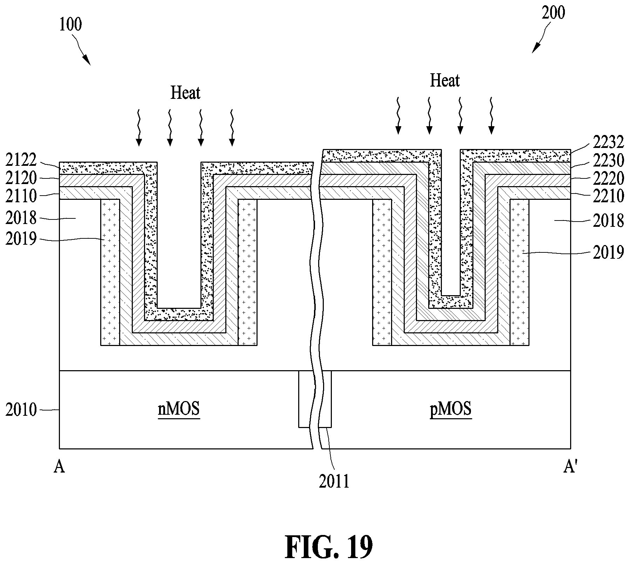

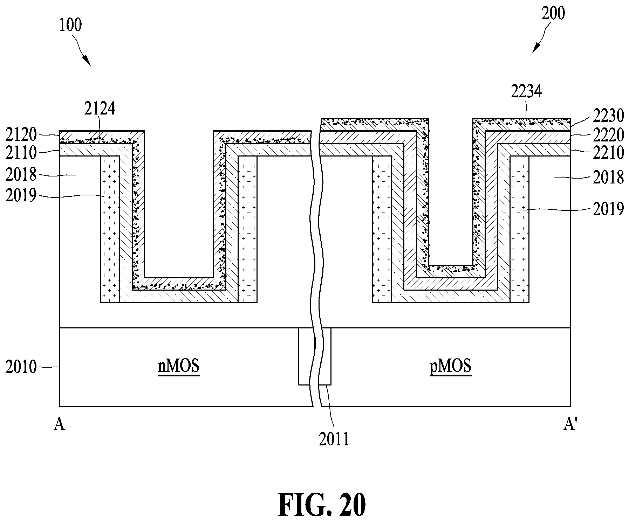

As shown in FIGS. 19 and 20, the first dipole thin film 2122 and the second dipole thin film 2232 may be heated at 600°C to 1000°C in an inert atmosphere (e.g., the N₂ atmosphere) so that the dipole materials are diffused into the first high dielectric layer 2120 and the second p-metal layer 2230.

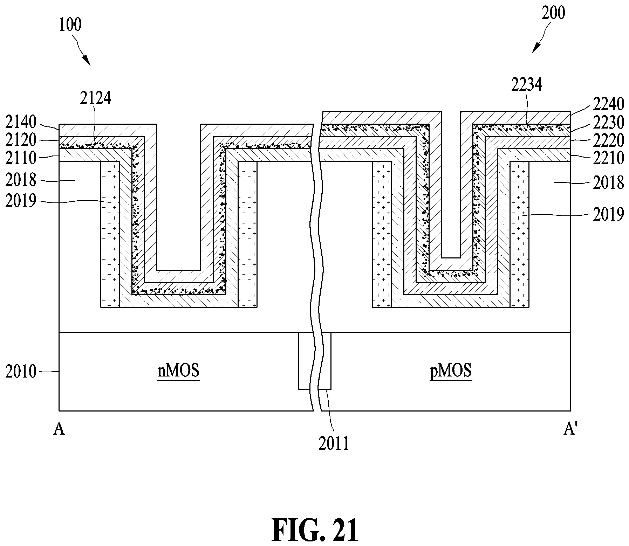

FIG. 21 illustrates a conceptual diagram of an operation of forming a first n-metal layer 2140 and a second n-metal layer 2240 respectively on the first high dielectric layer 2120 and the second p-metal layer 2230 according to at least one embodiment. The first n-metal layer 2140 and the second n-metal layer 2240 may be one layer with a step.

While embodiments of the disclosure are not limited thereto, the first n-metal layer 2140 and the second n-metal layer 2240 may be formed by ALD, and in this case, TiCl₄ may be used as a Ti precursor, which is a Ti providing source. There is a possibility that Cl decomposed from Ti reacts with La of a dipole material to be provided later and LaCl is formed (gate leakage (Jg) deterioration occurs). Therefore, the present disclosure proposes to form the first n-metal layer 2140 and the second n-metal layer 2240 with the low-Cl process to lower the possibility of formation of LaCl in the corresponding process, in addition to lowering the possibility of formation of LaCl by diffusing the dipole material as an example into the first high dielectric layer 2120 and the second p-metal layer 2230 and preventing (or mitigating the potential for) the dipole material from remaining and being exposed on the first high dielectric layer 2120 and the second p-metal layer 2230.

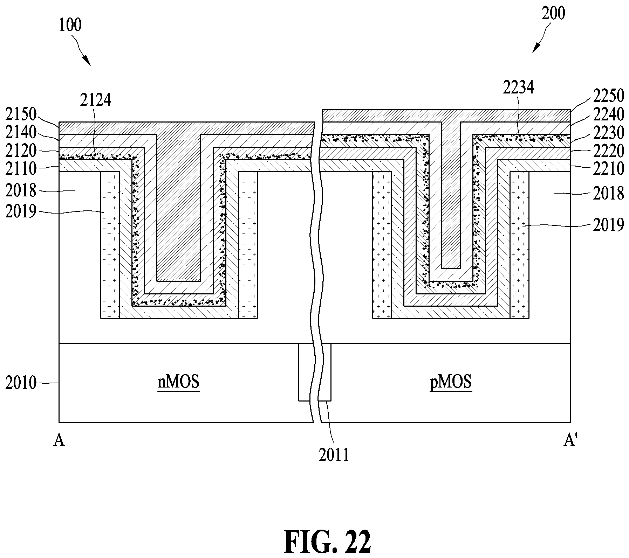

As shown in FIG. 22, a first fill metal 2150 and a second fill metal layer 2250 are formed respectively on the first n-metal layer 2140 and the second n-metal layer 2240. The first fill metal 2150 and the second fill metal layer 2250 may be formed to fill the entire internal space formed by the first n-metal layer 2140 and the second n-metal layer 2240.

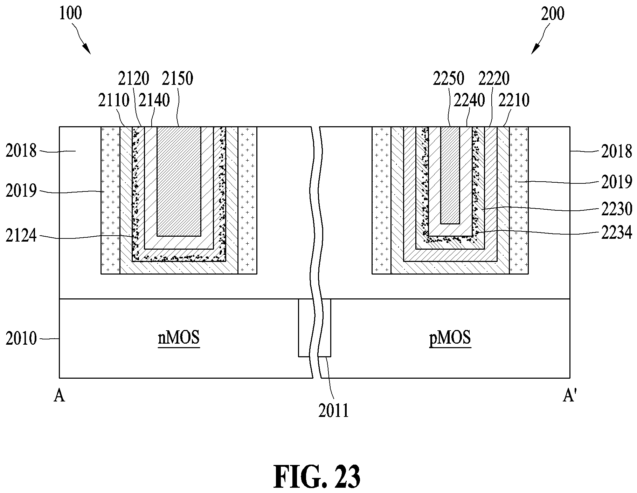

As shown in FIG. 23, the first interface layer 2110, the first high dielectric layer 2120, the first n-metal layer 2140, the first fill metal layer 2150, the second interface layer 2210, the second high dielectric layer 2220, the second p-metal layer 2230, the second n-metal layer 2240, and the second fill metal layer 2250 are removed to have the same height so that the insulating layer 2018 is exposed, thereby forming the n/p MOS gate stack having the 3D FinFET structure.

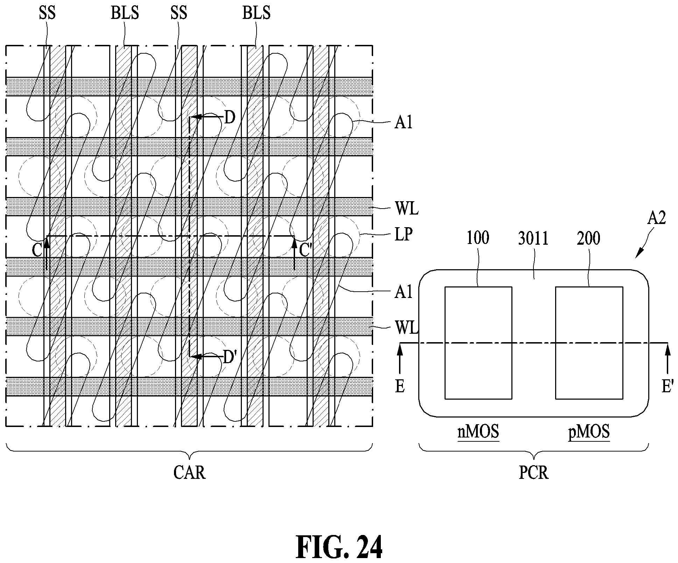

Referring to FIGS. 24 to 26, a semiconductor device according to at least one embodiment may include a cell array region CAR and a peripheral circuit region PCR. The nMOS stack 100 and the pMOS stack 200 may be separated by a device isolation region 3011.

The cell array region CAR may include memory cells. The cell array region CAR may include at least one of a memory cell of a volatile memory device and a memory cell of a non-volatile memory device. For example, cell transistors such as a dynamic random access memory (DRAM), a flash memory, etc. may be positioned in the cell array region CAR. The cell array region CAR may include a plurality of unit memory cells to store information. One unit memory cell may have at least one transistor and at least one capacitor.

The peripheral circuit region PCR may be positioned adjacent to the cell array region CAR. The peripheral circuit region PCR may be positioned on at least one side of the cell array region CAR. The peripheral circuit region PCR may be connected to the cell array region CAR by bonding metal wires to be positioned vertically. This structure may be referred to as cell over peri (COP), and may also be referred to as peri under cell (PUC). However, the arrangement relationship between the cell array region CAR and the peripheral circuit region PCR is not limited thereto and may be changed in various ways.

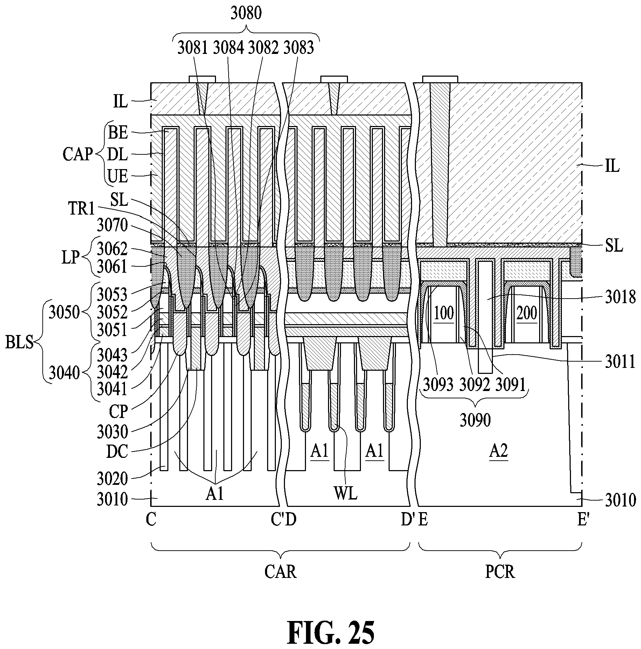

FIG. 24 is a plan view schematically showing a portion of a semiconductor device according to at least one embodiment, and FIG. 25 is a cross-sectional view taken along lines C-C', D-D', and E-E' of FIG. 24.

A device isolation film for separating the cell array region CAR and the peripheral circuit region PCR may be positioned between the cell array region CAR and the peripheral circuit region PCR. In the peripheral circuit region PCR, the nMOS stack 100 and the pMOS stack 200 may be separated by an insulating layer 3018.

The semiconductor device according to at least one embodiment may further include a core region positioned adjacent to the cell array region CAR. A driving circuit that generates a signal for driving a memory cell positioned in the cell array region CAR and a wire that transmits such a signal may be positioned in the core region and the peripheral circuit region PCR. For example, a sense amplifier and a write driver may be positioned in the core region, and a row decoder and a column decoder may be positioned in the peripheral circuit region PCR.

The semiconductor device according to at least one embodiment may include a substrate 3010 including the cell array region CAR and the peripheral circuit region PCR.

First device isolation films 3020 that define first active regions A1 may be disposed on the cell array region CAR of the substrate 3010. The substrate 3010 may be a semiconductor substrate containing silicon, germanium, silicon-germanium, and/or the like. The first active regions A1 may be positioned on an upper portion of the substrate 3010. The first active regions A1 may be formed by patterning the upper portion of the substrate 3010. Each of the first active regions A1 may have a rectangular (or bar) shape.

The first active regions A1 may be two-dimensionally arranged along a first direction and a second direction. The first active regions A1 may have long axes diagonally with respect to the first direction and second direction. A width of each of the first active regions A1 may decrease as it is away from a bottom surface of the substrate 3010 in a cross-section. That is, the width of each of the first active regions A1 in the first direction may become narrower as it goes in a direction (that is, a third direction) perpendicular to the upper surface of the substrate 3010.

Word lines WL may be positioned in the substrate 3010. The word lines WL may extend in the first direction on a plane to cross the first active regions A1 and the first device isolation film 3020. The word lines WL may be arranged along the second direction. A gate insulating film may be interposed between the word lines WL and the substrate 3010.

Specifically, gate recess regions may be formed in the first active regions A1 and the first device isolation film 3020. The gate insulating film may conformally cover inner side surfaces of the gate recess regions. The word lines WL may fill lower portions of the gate recess regions. The word lines WL may be spaced apart from the first active regions A1 and the first device isolation film 3020 with the gate insulating film therebetween. The upper surfaces of the word lines WL may be positioned below the upper surface of the substrate 3010. A gate capping layer may be positioned on the upper surface of the word lines WL and may fill a residue of the gate recess regions. A level of the upper surface of the gate capping layer may be substantially the same as a level of the upper surface of the substrate 3010.

Bit line structures BLS may extend in the second direction across the first active regions A1 on a plane. The bit line structures BLS may be insulated from and intersect with the word lines WL. The bit line structures BLS may include a bit line 3040 and a bit line capping pattern 3050 positioned above the bit line 3040.

The bit line 3040 may include a polysilicon pattern 3041, a silicide pattern 3042, and a metal pattern 3043 that are sequentially stacked. A lower insulating film may be interposed between the polysilicon pattern 3041 and the substrate 3010.

A bit line contact pattern DC may be positioned between the bit line 3040 and the first active region A1. The bit line 3040 may be electrically connected to the first active region A1 through the bit line contact pattern DC. A lower surface of the bit line contact pattern DC may be positioned below the upper surface of the substrate 3010 and may be positioned above the upper surfaces of the word lines WL. The bit line contact pattern DC may be formed in the substrate 3010 to be positioned in a recess region exposing the upper surface of the first active region A1. The recess region may have an oval shape in a plan view, and a width of the recess region in a short axis direction may be larger than a width of the bit line structures BLS.

The bit line capping pattern 3050 may be positioned on the metal pattern 3043 of the bit line 3040. The bit line capping pattern 3050 may include a first capping pattern 3051, a second capping pattern 3052, and a third capping pattern 3053 that are sequentially stacked.

A bit line contact spacer 3030 may fill a residue of the recess region where the bit line contact pattern DC is formed. For example, the bit line contact spacer 3030 may cover both side surfaces of the bit line contact pattern DC. In another example, the bit line contact spacer 3030 may surround the side surfaces of the bit line contact pattern DC in the recess region.

The bit line contact spacer 3030 may include an insulating material having an etching selectivity with respect to the lower insulating film. For example, the bit line contact spacer 3030 may include a silicon oxide film, a silicon nitride film, and/or a silicon oxynitride film, and may be formed of a multilayer film. The upper surface of the bit line contact spacer 3030 may be positioned at substantially the same level as the upper surface of the lower insulating film.

Bottom contacts CP may be positioned between the side surfaces of the bit line structures BLS. The bottom contacts CP may be arranged along the first direction on the side surfaces of the bit line structures BLS. Each of the bottom contacts CP may be disposed between the word lines WL and between the bit line structures BLS in a plan view. Each of the bottom contacts CP may come into contact with the substrate 3010 between two adjacent bit lines 3040 among the bit lines 3040. The bottom contact CP may be electrically connected to the first active region A1 of the substrate 3010. The bottom contact CP may include, for example, polysilicon doped with impurities.

A lower surface of the bottom contact CP may be positioned at a lower level than the upper surface of the substrate 3010 and may be positioned at a higher level than the lower surface of the bit line contact pattern DC. The upper surface of the bottom contact CP may be positioned below the lower surface of the bit line capping pattern 3050 of the bit line structure BLS. The bottom contact CP may be insulated from the bit line contact pattern DC by the bit line contact spacer 3030.

A landing pad LP may be positioned on the bottom contact CP. The landing pad LP may be electrically connected to the first active region A1 of the substrate 3010 through the bottom contact CP. An upper surface of the landing pad LP may be positioned above the upper surfaces of the bit line structures BLS, and a lower surface of the landing pad LP may be positioned below the upper surfaces of the bit line structures BLS.

The landing pad LP may include a barrier film 3061 and a pad metal pattern 3062 that are sequentially stacked. In another embodiment, a contact silicide pattern may be positioned between the bottom contact CP and the landing pad LP.

A spacer structure 3080 may be positioned between the bit line structures BLS and the bottom contact CP. The spacer structure 3080 may extend approximately in the second direction along the side surfaces of the bit line structures BLS.

The spacer structure 3080 may include a first spacer 3081, a second spacer 3082, a third spacer 3083, and a fourth spacer 3084. The first spacer 3081 may directly come into contact with the side surfaces of the bit line structures BLS. The second spacer 3082 may be disposed between the first spacer 3081 and the bottom contact CP. The third spacer 3083 may be disposed between the second spacer 3082 and the bottom contact CP. The second spacer 3082 may be positioned between the first spacer 3081 and the third spacer 3083. The first spacer 3081 and the third spacer 3083 may include an insulating material having an etching selectivity with respect to the lower insulating film.

The second spacer 3082 may include an insulating material having a lower dielectric constant than the first spacer 3081 and the third spacer 3083. For example, the first spacer 3081 and the third spacer 3083 may include a silicon nitride film, and the second spacer 3082 may include a silicon oxide film. In another example, the second spacer 3082 may include an air gap. That is, the second spacer 3082 may be an air spacer defined between the side surfaces of the first spacer 3081 and the third spacer 3083. The fourth spacer 3084 may be positioned on an upper surface of the second spacer 3082 and on a side surface of the first spacer 3081. The fourth spacer 3084 may surround a lower portion of the landing pad LP. The fourth spacer 3084 may have a ring shape in a plan view.

An insulating pattern 3070 may fill a space between the landing pads LP. The insulating pattern 3070 may surround the side surfaces of the landing pads LP. As shown in FIG. 25, the insulating pattern 3070 may be provided in a first trench TR1 between the side surfaces of the landing pads LP. The first trench TR1 may be a node isolation trench that electrically separates each of the landing pads LP. The landing pads LP may be spaced apart from each other with the first trench TR1 therebetween. The first trench TR1 may have inner surfaces defined by the surfaces of the landing pads LP, the bit line capping patterns 3050, and the spacer structure 3080. For example, the insulating pattern 3070 may include silicon nitride.

Capacitors CAP may be positioned on the landing pads LP, respectively. The capacitors CAP may be electrically connected to the landing pads LP, respectively. Each of the capacitors CAP may include a lower electrode BE, an upper electrode UE, and a dielectric layer DL between them. Each of the lower electrode BE and upper electrode UE may include, for example, one of titanium, tantalum, tungsten, copper, and aluminum.

Each of the lower electrode BE and the upper electrode UE may include at least one of doped silicon, Ru, RuO, Pt, PtO, Ir, IrO, SRO(SrRuO), BSRO((Ba,Sr)RuO), CRO(CaRuO), BaRuO, La(Sr,Co)O, Ti, TiN, W, WN, Ta, TaN, TiAlN, TiSiN, TaAlN, TaSiN, and/or a combination thereof.

The dielectric layer DL may include, for example, at least one of hafnium oxide, hafnium silicon oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, lead zinc niobate, and/or a combination thereof.

An insulating layer IL and a capacitor contact via that penetrate the insulating layer IL to be connected to the capacitor CAP may be positioned on the capacitor CAP. The capacitor contact via may be connected to the upper electrode UE of the capacitor CAP.

A cell signal wire may be positioned on the insulating layer IL. The cell signal wire may be positioned above the capacitor contact via and may be electrically connected to the capacitor contact via. The cell signal wire may be electrically connected to the capacitor CAP through the capacitor contact via. The upper electrode UE of the capacitor CAP may receive a predetermined voltage through the cell signal wire.

The peripheral circuit region PCR of the semiconductor device according to at least one embodiment may include a gate stack, a gate spacer structure, an interlayer insulating film, a peripheral contact, peripheral circuit wires BP, wire insulating patterns, an etching stop layer SL, the insulating layer IL, a contact plug, and a peripheral signal wire.

The specific configuration of the gate stacks 100 and 200 of the peripheral circuit region PCR of the semiconductor device according to at least one embodiment may be the n/p MOS gate stack of FIG. 1 and/or the n/p MOS of FIG. 12.

As shown in FIG. 25, a gate spacer structure 3090 may be positioned on a side surface of a gate stack. The gate spacer structure may include a first gate spacer 3091, a second gate spacer 3092, and a third gate spacer 3093.

The first gate spacer 3091 may be positioned on the side surface of the gate stack. The first gate spacer 3091 may extend in the third direction along the side surfaces of the gate stack. The first gate spacer 3091 may have a lower oxygen element content ratio than the second gate spacer 3092. The first gate spacer 3091 may have a first dielectric constant, and the first dielectric constant may have a value in a range of about 6.5 to 7.5. The first gate spacer 3091 may include a material that has an etching selectivity with the first dielectric layer. The first gate spacer 3091 may include, for example, silicon nitride. An upper surface of the first gate spacer 3091 may be substantially the same as the upper surface of the gate capping pattern. The first gate spacer 3091 may directly come into contact with the side surface of the gate electrode and the side surface of the gate capping pattern.

The second gate spacer 3092 may be positioned above the first gate spacer 3091. The second gate spacer 3092 may have a larger width than the first gate spacer 3091. A width of the second gate spacer 3092 may decrease as it goes away from the upper surface of the substrate 3010. The second gate spacer 3092 may include, for example, silicon oxide.

The third gate spacer 3093 may be positioned above the second gate spacer 3092. The third gate spacer 3093 may cover the upper surface of the first gate spacer 3091 and the upper surface of the gate capping pattern. The third gate spacer 3093 may extend along the upper surface of the substrate 3010.

An interlayer insulating film may be positioned on the substrate 3010. The interlayer insulating film may cover the side surfaces of the gate spacer structure 3090 and may not cover the upper surface of the gate spacer structure 3090. The upper surface of the interlayer insulating film may be substantially the same as the upper surface of the third gate spacer 3093. The interlayer insulating film may include a high-density-plasma (HDP) oxide film or a silicon oxide film formed by a flowable chemical vapor deposition (FCVD) method. The interlayer insulating film may include a first interlayer insulating film and a second interlayer insulating film.

The peripheral circuit wires BP may be positioned on the interlayer insulating film. The peripheral circuit wires BP positioned in the peripheral circuit region PCR may extend in a direction parallel to the upper surface of the substrate 3010.

In at least one embodiment, the peripheral circuit wire BP may extend in the second direction parallel to the substrate 3010 and may have a line shape or a bar shape in a plan view. The peripheral circuit wire BP may be arranged to be spaced apart in the first direction that intersects with the second direction.

The number and the arrangement of the peripheral circuit wires BP arranged in the peripheral circuit region PCR of FIG. 25 are not limited thereto as an example and may be changed in various ways.

The peripheral circuit wire BP may be positioned on the same layer as the pad metal pattern 3062 of the landing pad LP positioned in the cell array region CAR. The peripheral circuit wire BP may be formed in the same process using the same material as the pad metal pattern 3062.

The peripheral circuit wire BP may be connected to impurity regions through peripheral contacts. The peripheral contact and peripheral circuit wire BP may include, for example, at least one of copper (Cu), tungsten (W), aluminum (Al), tantalum (Ta), and titanium (Ti).

The peripheral contact may be connected to the substrate 3010 by penetrating the interlayer insulating film. A lower end of the peripheral contact may be positioned at a lower level than the upper surface of the substrate 3010. The peripheral contact may electrically connect the peripheral circuit wire BP and the impurity regions.

A contact barrier film may include, e.g., metal nitride. The contact barrier film may include, for example, at least one of titanium nitride (TiN), tantalum nitride (TaN), and tungsten nitride (WN).

The etching stop layer SL may cover the insulating pattern 3070, the wire insulating pattern, and the peripheral circuit wires BP. The insulating layer IL may be positioned on the etching stop layer SL.

The contact plug may penetrate the insulating layer IL and the etching stop layer SL to be connected to the peripheral circuit wires BP.

The contact plug positioned in the peripheral circuit region PCR may be positioned on the same layer as the capacitor contact via positioned in the cell array region CAR. The contact plug may be formed in the same process using the same material as the capacitor contact via.

The peripheral signal wire may be positioned above the insulating layer IL. The peripheral signal wire may be positioned above the contact plug and may be electrically connected to the contact plug. The peripheral signal wire may be electrically connected to the peripheral circuit wire BP through the contact plug. The peripheral circuit wire BP may receive a predetermined signal through the peripheral signal wire.

The peripheral signal wire positioned in the peripheral circuit region PCR may be positioned on the same layer as the cell signal wire positioned in the cell array region CAR. The peripheral signal wire may be formed in the same process using the same material as the cell signal wire.

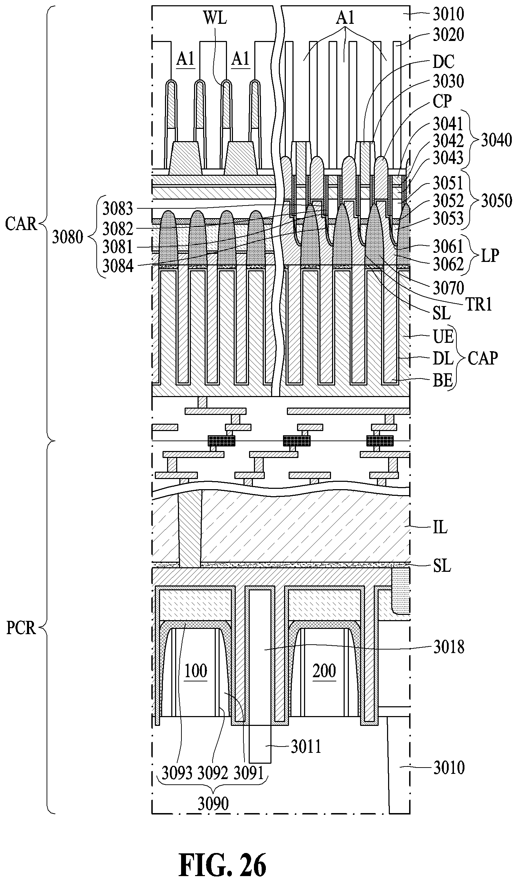

FIG. 26 illustrates a conceptual cross-sectional view of a semiconductor device having a COP structure according to at least one embodiment. According to at least one embodiment, the peripheral circuit region PCR and the cell array region CAR may be arranged vertically. The peripheral circuit region PCR and the cell array region CAR may be connected by bonding of wires (cell signal wires or peripheral signal wires). The peripheral circuit region PCR may be stacked on the cell array region CAR, or the cell array region CAR may be stacked on the peripheral circuit region PCR. In the semiconductor device having the COP structure according to at least one embodiment, a thickness of the peripheral circuit region PCR may be made different from the entire thickness of the cell array region CAR. Accordingly, a thickness of the insulating layer IL of the peripheral circuit region PCR and a length of the contact plug formed on the insulating layer IL may be reduced.

The semiconductor device including the peripheral circuit region PCR and the cell array region CAR including the n/p MOS gate stack of the present disclosure may be a component of a high bandwidth memory (HBM) for a 3D stacked DRAM.

As described above, although the embodiments have been described with reference to the above drawings, a person skilled in the art may apply various technical modifications and variations. For example, suitable results may be achieved if the described techniques are performed in a different order, and/or if components in a described system, architecture, device, or circuit are combined in a different manner, or replaced or supplemented by other components or their equivalents within the scope of the appended claims.

## Claims

1. An n/p metal-oxide-semiconductor, MOS, gate stack comprising:
a semiconductor substrate (1010; 2010) having an nMOS region and a pMOS region;
an nMOS stack (100) on the nMOS region, the nMOS stack (100) comprising a first interface layer (1110; 2110), a first high dielectric layer (1120; 2120), a first n-metal layer (1140; 2140), and a first upper electrode (1150; 2150) sequentially stacked; and
a pMOS stack (200) on the pMOS region, the pMOS stack (200) comprising a second interface layer (1210; 2210), a second high dielectric layer (1220; 2220), a second p-metal layer (1230; 2230) formed on the second high dielectric layer (1220; 2220), a second n-metal layer (1240; 2240), and a second upper electrode (1250; 2250) sequentially stacked,
wherein the first high dielectric layer (1120; 2120) comprises a first dipole material (1124; 2124), and
the second p-metal layer (1230; 2230) comprises a second dipole material (1234; 2234).

2. The n/p MOS gate stack of claim 1, wherein
the first interface layer (1110; 2110) and the second interface layer (1210; 2210) each comprise at least one of SiO₂ or SiON,
the first high dielectric layer (1120; 2120) and the second high dielectric layer (1220; 2220) each comprise at least one of HfO, HfSiO, or HfSiON, and
the first n-metal layer (1140; 2140), the second n-metal layer (1240; 2240), and the second p-metal layer (1230; 2230) each comprise at least one of TiN, TiO₂, TiON, TiSiN, TiAl, or TiAlN.

3. The n/p MOS gate stack of claim 1 or 2, wherein
the first dipole material (1124; 2124) comprises La₂O₃, and
the first dipole material (1124; 2124) is diffused into the first high dielectric layer (1120; 2120).

4. The n/p MOS gate stack of claim 3, wherein the first dipole material (1124;
2124) is diffused to an interface between the first high dielectric layer (1120; 2120) and the first interface layer (1110; 2110).

5. The n/p MOS gate stack of any one of claims 1 to 4, wherein
the second dipole material (1234; 2234) comprises La₂O₃, and
the second dipole material (1234; 2234) is at least one of in a thin film region on an upper end portion of the second p-metal layer (1230; 2230) or diffused into the second p-metal layer (1230; 2230).

6. The n/p MOS gate stack of claim 5, wherein the second dipole material (1234; 2234) diffused into the second p-metal layer(1230; 2230) is diffused to the upper end portion of the second p-metal layer (1230; 2230).

7. The n/p MOS gate stack of claim 5 or 6, wherein a diffusion concentration of the second dipole material (1234; 2234) in the upper end portion of the second p-metal layer (1230; 2230) is greater than a diffusion concentration of the second dipole material (1234; 2234) in a lower end portion of the second p-metal layer (1230; 2230).

8. The n/p MOS gate stack of any one of claims 1 to 7, wherein
the second p-metal layer (1230; 2230) has a thickness within a range of 10 Å to 100 Å, and
a concentration of chlorine, Cl, in the second p-metal layer (1230; 2230) is within a range of 0% and 5% by weight.

9. The n/p MOS gate stack of any one of claims 1 to 8, wherein an interface between the first high dielectric layer (1120; 2120) and the first n-metal layer (1140; 2140) and an interface between the second p-metal layer (1230; 2230) and the second n-metal layer (1240; 2240) are LaCl-free.

10. The n/p MOS gate stack of any one of claims 1 to 9, wherein the n/p MOS gate stack comprises at least one of a planar structure or a three-dimensional, 3D, structure of a recess gate, a fin field effect transistor, FinFET, or a Gate-All-Around, GAA, transistor.

11. A method of manufacturing an n/p metal-oxide-semiconductor, MOS, gate stack, the method comprising:
preparing a substrate (1010; 2010);
forming a first interface layer (1110; 2110) in an nMOS region of the substrate (1010; 2010) and a second interface layer (1210; 2210) in a pMOS region of the substrate (1010; 2010);
forming a first high dielectric layer (1120; 2120) and a second high dielectric layer (1220; 2220) on the first interface layer (1110; 2110) and the second interface layer (1210; 2210), respectively;
forming a first p-metal layer (1130; 2130) and a second p-metal layer (1230; 2230) on the first high dielectric layer (1120; 2120) and the second high dielectric layer (1220; 2220), respectively;
exposing the first high dielectric layer (1120; 2120) by removing the first p-metal layer (1130; 2130) formed on the first high dielectric layer (1120; 2120);
forming a first dipole thin film (1122; 2122) and a second dipole thin film (1232; 2232) on the exposed high dielectric layer and the second p-metal layer (1230; 2230), respectively;
performing a heat treatment on the first dipole thin film (1122; 2122) and the second dipole thin film (1232; 2232) such that the first dipole thin film (1122; 2122) and the second dipole thin film (1232; 2232) diffuse into the exposed high dielectric layer and the second p-metal layer (1230; 2230), respectively;
exposing the first high dielectric layer (1120; 2120) and the second p-metal layer (1230; 2230) by removing a residue of the first dipole thin film (1122; 2122) and a residue of the second dipole thin film (1232; 2232);
forming, after removing the residue of the first dipole thin film (1122; 2122) and the residue of the second dipole thin film (1232; 2232), a first n-metal layer (1140; 2140) and a second n-metal layer (1240; 2240) on the exposed first high dielectric layer (1120; 2120) and the exposed second p-metal layer (1230; 2230), respectively; and
forming a first upper electrode (1150; 2150) and a second upper electrode (1250; 2250) on the first n-metal layer (1140; 2140) and the second n-metal layer (1240; 2240), respectively.

12. The method of claim 11, wherein each of the forming of the first interface layer (1110; 2110), the second interface layer (1210; 2210), the first high dielectric layer (1120; 2120), the second high dielectric layer (1220; 2220), the first p-metal layer (1130; 2130), the second p-metal layer (1230; 2230), the first dipole thin film (1122; 2122), the second dipole thin film (1232; 2232), the first n-metal layer (1140; 2140), and the second n-metal layer (1240; 2240) includes at least one deposition method.

13. The method of claim 11, wherein the forming of the first p-metal layer, the second p-metal layer (1230; 2230), the first n-metal layer (1140; 2140), and the second n-metal layer (1240; 2240) is performed under at least one of an H₂, N₂, NH₃, SiH₄, or dichlorosilane gas atmospheres.

14. The method of claim 11, wherein the removing the first p-metal layer (1130; 2130) formed on the first high dielectric layer (1120; 2120) includes patterning the first p-metal layer (1130; 2130) through a strip using at least one of a photoresist or a bottom anti-reflection coating, BARC.

15. A semiconductor device including:
a cell array region (CAR); and
a peripheral circuit region (PCR) adjacent to the cell array region (CAR) and including drive circuitry configured to enable driving of a memory cell included in the cell array region (CAR),
wherein the drive circuitry includes the n/p MOS gate stack of any one of claims 1 to 10.
